# NEW EUROPEAN PATENT SPECIFICATION

(11) **EP 0 341 756 B2**
(45) Date of publication and mention of the opposition decision: **30.06.1999**
(45) Mention of the grant of the patent: 03.08.1994
(21) Application number: 89111929.9
(22) Date of filing: 03.11.1982
(51) Int. Cl.: H01L 31/04, H01L 31/0216

(54) **Flexible photovoltaic device**
Biegsame photovoltaische Vorrichtung
Dispositif photovoltaique flexible

(30) Priority: 04.11.1981 JP 17768581; 15.12.1981 JP 20315581; 28.12.1981 JP 21311981; 09.04.1982 JP 6010982
(43) Date of publication of application: 15.11.1989
(62) Divisional of application: 82110122.7
(73) Proprietor: KANEGAFUCHI KAGAKU KOGYO KABUSHIKI KAISHA, Kita-ku Osaka-shi Osaka-fu 530 (JP)
(72) Inventor: Hamakawa, Yoshihiro, Kawanishi-shi Hyogo-ken (JP); Tawada, Yoshihisa, Kobe-shi Hyogo-ken (JP); Tsuge, Kazunori, Kobe-shi Hyogo-ken (JP); Izumina, Masanobu, Omiya-shi Saitama-ken (JP)
(74) Representative: Türk, Gille, Hrabal

(56) References cited:
- EP-A- 0 025 872
- DE-A- 2 522 217
- US-A- 4 281 208
- PATENT ABSTRACTS OF JAPAN, vol. 4, no. 59 (E-9)[541], 2nd May 1980; & JP-A-55 29 154
- PATENT ABSTRACTS OF JAPAN, vol. 4, no. 8 (E-166), 22nd January 1980; & JP-A-54 149 489
- PATENT ABSTRACTS OF JAPAN, vol. 5, no. 99 (E-63)[771], 26th June 1981; & JP-A-56 43 774
- APPLIED PHYSICS LETTERS, vol. 39, no. 3, August 1981, pages 237-239, New York, US; Y. TAWADA et al.: "a-SiC:H/a-Si:H heterojunction solar cell having more than 7.1% conversion efficiency"
- JOURNAL OF THE ELECTROCHEMICAL SOCIETY, vol. 122, no. 12, December 1975, pages 1681-1685, Princeton, US; T.L. CHU et al.: "Polycrystalline silicon on coated steel substrates"
- Philosophical magazine vol 35,1977, pages 1-16
- W-A-79 00776

## Description

The present invention is a divisional application of EP-A-82 110 122.7 (EP-B-0 078 541) The present invention relates to a flexible photovoltaic device comprising a substrate including a metal foil and an electric insulating thin film, and a photovoltaic device body of a non-single-crystal semiconductor, the body being formed over said electric insulating thin film and an electrode layer being interposed between the body and the electric insulating thin film.

Photovoltaic devices such as solar cells and photodetector are capable of converting solar radiation into usable electrical energy. However, the devices of this type have the large problem to be overcome that the generating cost is very large as compared with other means for generating electric energy. The main reasons are that the efficiency of utilizing a semiconductor material constituting the body of the device is low and much energy is required in producing the semiconductor material. In recent years, it has been proposed to use amorphous silicon as a material of semiconductors, and this proposal has been considered as a technique having a possibility of overcoming the above problems. The amorphous silicon can be produced inexpensively and in large quantities by a glow discharge decomposition of silicon compounds such as silane and fluorosilane. The amorphous silicon so prepared has a low average density of localized state in the band gap, namely not more than 10¹⁷ eV⁻¹cm.⁻³, and impurity doping of N type or P type is possible in the same manner as in the preparation of crystalline silicon.

A representative prior art solar cell using amorphous silicon is one prepared by forming a transparent electrode on a glass substrate capable of transmitting visible rays, forming a P-type amorphous silicon layer, an undoped amorphous silicon layer and a N-type amorphous silicon layer on the transparent electrode in that order by a glow discharge, and providing an ohmic contact electrode on the N-type layer. If light enters into the P-type layer, undoped layer and N-type layer through the glass substrate and transparent electrode, electron-hole pairs are mainly generated in the undoped layer. They are attracted by the PIN junction internal electric field created by the above-mentioned each layer to be transferred and is collected to the ohmic contact electrode to generate a voltage between the both electrodes. In solar cells of such a type, the open-circuit voltage is about 0.8 V, and accordingly the cells are not used as they are as a power source for equipments requiring a large power source voltage.

In order to overcome this drawback, it is proposed to raise the voltage by forming separately plural generating zones on a single substrate and contacting the respective generating zones in series, as disclosed in Japanese Unexamined Patent Publication (Tokkyo Kokai) No. 107276/1980. However, the solar cells prepared according to this proposal still has the drawbacks that a large surface area is required due to low efficiency, and that series connection of multiple devices is necessary because the voltage per one device is about 0.8 V. Also, the solar cell has no flexibility due to the use of a rigid substrate such as glass. On the other hand, flexible solar cells are demanded in the field of electronic machines because of development of a flexible printed board and a film liquid crystal display.

A solar cell using a polymer thin film rich in flexibility and heat resistance, such as polyimide, as a substrate is disclosed in Japanese Unexamined Patent Publication No. 149489/1979. However, the use of the polymer film as a substrate has the disadvantages that the substrate is curled during the deposition in the preparation of amorphous silicon and no flat solar cell is obtained, and that the substrate is not uniformly heated due to the deformation during the deposition and uniform amorphous silicon layers are formed.

EP-A-0 041 773 published on 16.12.81, having a priority date of 19.05.80 and belonging to the state of the art according to Article 54(3) EPC as far as the Contracting States DE, FR, GB, IT, NL, are concerned discloses a flexible photovoltaic device which is wound on a roll, comprising a metal foil, an insulative coating of Si₃N₄, an electrode layer, and an amorphous Si photovoltaic body.

It is an object of the present invention to provide a flexible photovoltaic device.

A further object of the invention is to provide a flexible and heat resistant photovoltaic device.

Another object of the invention is to provide a flexible, small-sized photovoltaic device having a plurality of generating zones on a single substrate.

Still another object of the invention is to provide a flexible integrated solar cell capable of generating an increased open-circuit voltage.

These and other objects of the present invention will become apparent from the description hereinafter.

In accordance with the present invention, there is provided a flexible photovoltaic device comprising a substrate (1) including a metal foil (1 a) and an electric insulating thin film (1 b), and a photovoltaic device body (3) of an amorphous silicon semiconductor, the body being formed over said electric insulating thin film and an electrode layer (2) of a metal thin film being interposed between the body and the electric insulating thin film and being in ohmic contact with the amorphous silicon semiconductor, characterized in that said insulating thin film (1 b) is a layer of an inorganic material having an electric conductivity of not more than 10⁻⁹ (Ω cm)⁻¹ during light impingement, said inorganic material being an amorphous material selected from the group consisting of silicon carbide Si₍₁₋ₓ₎Cₓ, silicon nitride Si_{1-y}N_{y}, silicon carbon nitride Si_{(1-x-y})CₓN_{y} and their hydrides for the Contracting States BE, CH, LI. For the Contracting States DE, FR, GB, IT, NL, Si₃N₄ is excepted from the silicon nitride Si_{1-y}N_{y}.
Fig. 1 is a perspective view showing an embodiment of the photovoltaic device of the present invention;
Fig. 2 is a schematic view of an apparatus for forming an amorphous semiconductor thin film and an amorphous semiconductor photovoltaic device body composed of the amorphous semiconductor thin film layers of the photovoltaic device of the present invention by a plasma glow discharge method or a sputtering method;
Fig. 3A is a schematic view illustrating a basic structure of a PIN junction photovoltaic device of the type that the light impinges on the P-layer side;
Fig. 3B is a schematic view illustrating a basic structure of a PIN junction photovoltaic device of the type that the light impinges on the N-layer side;
Fig. 4 is a diagram showing an energy band profile of the PIN heterojunction photovoltaic device of the present invention:
Fig. 5A is a schematic plan view showing an embodiment of the photovoltaic device of the present invention in which a plurality of generating zones provided on a single substrate are connected in series:
Fig. 5B is a vertical cross-sectional view taken along the line X-X of Fig. 5A; and
Fig. 5C is a vertical cross-sectional view taken along the line Y-Y of Fig. 5A.

The substrate used in the present invention is an electrically insulated metal foil, in other words, a metal foil on which an electric insulating thin film is formed. The substrate is flexible and heat resistant, and accordingly it does not curl during deposition of non-single-crystalline semiconductors and can be employed in the same manner as conventional substrates such as a glass plate and a stainless steel plate to provide flexible photovoltaic devices.

A foil or thin film of a metal having a Young's modulus of not less than 8 x 10³ kg./mm.² is employed in the present invention as a metal foil for constituting the flexible substrate. The metal includes, for instance, aluminum, copper, iron, nickel, stainless steel, and the like. The thickness of the metal foil is selected from 5 µm. to 2 mm., preferably from 50 µm. to 1 mm.

Inorganic materials having an electric conductivity of not more than 10⁻⁹ (Ω·cm.)⁻¹, at the time of light impinging are employed as materials of the electric insulating thin film.

A flexible and heat resistance polymer thin film may be interposed between the metal foil and the inorganic material film and may be formed of polyimide, polyamide, polyamidimide, polyhydantoin, polyparabanic acid, poly-p-xylylene, silicone and cyclized polybutadiene homopolymer and copolymers. The thickness of the polymer layer is from 100 nm (1,000 angstroms) to 100 µm, preferably from 1 to 20 µm. The polymer film is formed in a usual application manner. For instance, a varnish is prepared by dissolving a polymer or a precursor thereof in a solvent, applied on the surface of a metal foil by spraying, dipping, coating or printing, and is then dried and hardened by heating, ion bombarding or irradiation of ultraviolet rays, β rays, τ rays or electrom beam.

According to the invention the inorganic material film used as the electric insulating layer of the substrate is selected from amorphous silicon carbide, silicon nitride and silicon carbon nitride, i.e. Si₍₁₋ₓ₎Cₓ, Si_{(1-y)}N_{y}, Si_{(1-x-y)}CₓN_{y}, the hydrides thereof, i.e. Si₍₁₋ₓ₎Cₓ:H, Si_{(1-y)}N_{y}:H and Si_{(1-x-y)}CₓN_{y}:H. The above amorphous silicon compound thin film can be obtained by sputtering or glow discharge decomposition. In case of the sputtering, the desired thin film is obtained by employing polycrystalline SiC or Si₃N₄ as a target, or by employing Si and graphite, etc. as a target. In case of the glow discharge decomposition, the desired fhin film is obtained by a glow discharge in a mixture of a silicon compound such as silane and a carbon and/or nitrogen compound. In that case, preferably a doping gas is not employed, but the silicon compound may be doped with an impurity such as boron or phosphorus so long as the electric conductivity of the obtained thin film is not more than 10⁻⁹ (Ω·cm.)⁻¹, at the time of light impinging. The thickness of the inorganic material film used as an electric insulating layer is not particularly limited so long as a metal foil or film is electrically insulated. The thickness is usually selected from 10 nm (100 angstroms) to 20 µm.

The electric insulating layer may be a combination of the polymer thin film contiguous to the metal foil and an inorganic material thin film contiguous to a lower electrode of the photovoltaic device to be fabricated. In that case, if necessary, at least one intermediate layer made of another material may be further provided between the polymer thin film and the inorganic material thin film. The use of the combination of the polymer film and the inorganic material film as an electric insulation layer is advantageous in that there is avoided the lowering of the device characteristics which may occur, in case of using only a polymer film as an insulation layer, during the device fabrication due to generation of a gas from the polymer, occurrence of release at the interface between the insulation layer and the device or occurrence of cracks in the device, and in that the flexibility is improved by the decrease of the thickness of the inorganic material film and moreover the insulation and the surface smoothness of the substrate are improved.

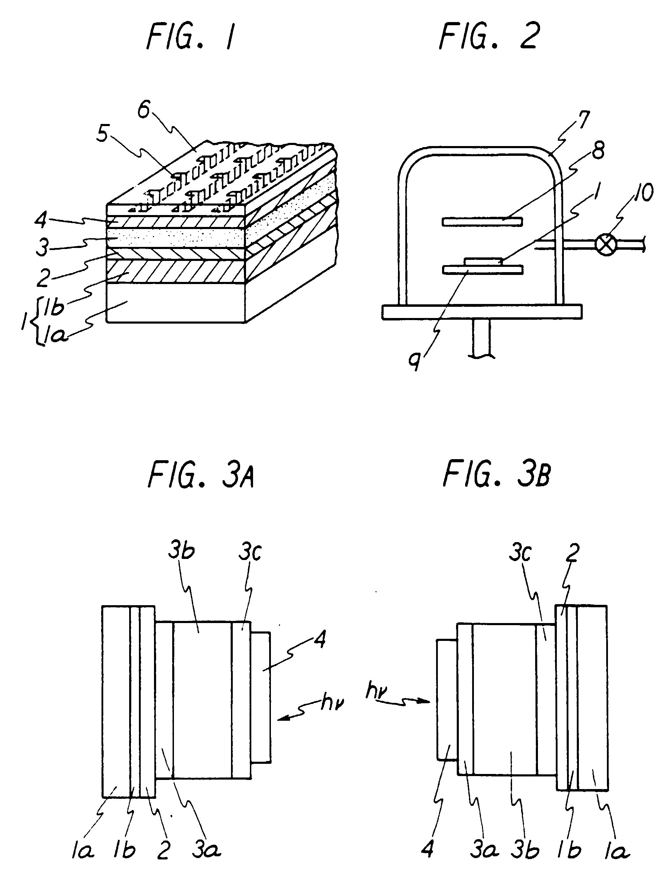

Referring to Fig. 1 which shows an embodiment of a flexible thin film solar cell according to the present invention, a substrate is designated as 1. An electric insulating layer 1b, a flexible, heat resistant inorganic material thin film is formed on a metal foil 1a. On the surface of the insulation layer 1b, a lower electrode 2 which comes into ohmic contact with a P-type or N-type amorphous semiconductor is formed in a desired pattern in a thickness of about 50 nm (500 angstroms) to about 1 µm. by deposition or sputtering. Examples of the metal of the electrode 2 are aluminum, molybdenum, stainless steel, nickel, platinum, gold and silver. On the surface of the electrode 3 is a photovoltaic device body 3 composed of amorphous silicon semiconductor layers. The photovoltaic device body 3 is prepared in a thickness of 0.2 to 2 µm. by a plasma glow discharge method or a sputter deposition method. A transparent electrode layer 4 which acts as a potential barrier to the photovoltaic device body 3 and through which most of the light can transmit, e.g. Pt, ITO, SnO₂, or a composite of ITO and SnO₂, is formed on the photovoltaic device body 3 by deposition in a thickness of 50 to 300 nm (500 to 3,000 angstroms). On the transparent electrode layer 4 is a comb-shaped electrode grid 5 made of Al, Ag, Ti-Ag, Pd, or the like. A reflection inhibiting layer 6, e.g. zirconium oxide film, may be provided, as occasion demands. Also, if necessary, a passivation film is further provided on the reflection inhibiting layer 6.

Fig. 2 is a schematic view of a vacuum apparatus for forming an amorphous silicon thin film and for fabricating the amorphous silicon photovoltaic device body 3 including the amorphous silicon thin film layers by a plasma glow discharge method or a sputtering deposition method. In Fig. 2, numerals 8 and 9 are electrodes and numeral 10 is a valve for introducing a predetermined gas into a vacuum chamber 7. A substrate 1 with a lower electrode 2 for the photovoltaic device is mounted on the electrode 9 with the lower electrode 2 facing up. In case of the plasma glow discharge method, after evacuating the chamber 7 to a pressure of 1 x 10⁻⁶ to 10 x 10⁻⁶ Torr (1 Torr = 133.32 Pa), a gas such as SiH₄ is introduced into the chamber through the valve 10 up to a pressure of 10⁻² to 5 Torr with or without a dopant gas. A DC voltage or a RF voltage of 1 to several tens of MHz is then applied between the electrodes 8 and 9, thereby causing a plasma to generate. This state is maintained for several tens of minutes, thus the photovoltaic device body 3 including for example an intrinsic amorphous silicon thin film layer having a thickness of 0.1 to 1 µm., a carrier lifetime of not less than 10⁻⁷ second, a density of localized state of not more than 10¹⁷/cm.³eV and a carrier mobility of not less than 10⁻³ cm.²/v.sec. is formed on the surface of the electrode 2.

In case of the sputtering deposition method, after evacuating the chamber 7 to a pressure of 1 x 10⁻⁶ to 10 x 10⁻⁶ Torr, a mixed gas of hydrogen or the like and an inert gas such as argon is introduced into the chamber through the valve 10 up to a pressure of 5 x 10⁻³ to 10⁻¹ Torr. A DC voltage or a RF voltage of 1 to several tens of MHz is then applied between the electrode 8 having a target and the electrode 9 on which the substrate with the lower electrode 2 for the photovoltaic device is mounted, thereby causing a plasma to generate in the chamber. A voltage of about 1 to 3 kV, an electric current of 100 to 300 mA and a power of 100 to 300 W are sufficient. If the above state is maintained for about 60 minutes, the amorphous silicon photovoltaic device body 3 including an intrinsic amorphous silicon thin film layer having a thickness of 0.1 to 1 µm., a carrier lifetime of not less than 10⁻⁷ second, a density of localized state of not more than 10¹⁷/cm.³eV and a carrier mobility of not less than 10⁻³ cm.²/V.sec.

In case of employing such semiconductors in photovoltaic devices, a small thickness is sufficient because they have a large optical absorption coefficient, and accordingly such semiconductors are suitable for use in flexible solar cells.

The lower electrode 2 for ohmic contact and the transparent electrode layer 4 can be formed by a resistance heating method, electron beam deposition method or sputtering deposition method.

Preferably, the photovoltaic device body 3 is of a three layer structure. For instance, the first layer is a P-type amorphous silicon thin film having a boron concentration of not less than 10¹⁹/cm.³, the second layer is an intrinsic amorphous silicon thin film, and the third layer is a N-type amorphous silicon thin film having a phosphorus concentration of not less than 10¹⁹/cm³. The first layer may be of a N-type conductivity and the third layer may be of a P-type conductivity. The short-circuit current and the open circuit voltage can be largely improved by employing at least as a window material a P-type or N-type amorphous silicon semiconductor having an optical band gap of not less than about 1.85 eV, an electric conductivity of not less than about 10⁻⁸ (Ω·cm.)⁻¹ at 20°C. and a diffusion potential (exhibited in PIN junction) of not less than about 1.1 volts. In case of using the above-mentioned photovoltaic device body 3 as a solar cell, the solar cell is constructed so that an open circuit voltage may be taken out to the outside by radiating light from the side of the transparent electrode 4 such as Pt or ITO electrode, thereby causing electron-hole pairs to generate in the photovoltaic device body 3 by the light and causing these electrons and holes to reach a depletion layer region.

In Figs. 3A and 38, representative examples of the basic construction of the photovoltaic device of the present invention are shown. Illustrated in Fig. 3A is a photovoltaic device of the type that light impinges on the P-layer side. For instance, the device of this type has a construction of stainless steel foil-insulating film-electrode-N-I-P-transparent electrode. Illustrated in Fig. 3B is a photovoltaic device of the type that light impinges on the N-layer side. For instance, the device of this type has a construction of stainless steel foil-insulating film-electrode-P-I-N-transparent electrode. Optionally, other constructions may be formed by interposing a thin insulation layer or a thin metal layer between the P-layer or N-layer and the transparent electrode. Any construction suffices so far as the PIN junction is included as the basic component.

In the above PIN junction, there is employed, as an I-layer of the photovoltaic device, an intrinsic amorphous silicon (hereinafter referred to as "I-type a-Si") having a carrier lifetime of not less than about 10⁻⁷ second, a density of localized state of not more than about 10¹⁷ cm.⁻³eV⁻¹ and a mobility of not less than 10⁻³ cm.²/V.sec., which is prepared by a glow discharge decomposition of silane or its derivatives, fluorosilane or its derivatives, or a mixture thereof. Such an I-type a-Si layer is joined with P-type and N-type doped amorphous or microcrystalline silicon semiconductors to give a PIN junction structure. Preferably, at least one of the P-layer and N-layer is a doped amorphous or microcrystalline semiconductor having an optical band gap of not less than about 1.85 eV, an electric conductivity of not less than about 10⁻⁸ (Ω·cm.)⁻¹ at 20°C. and a diffusion potential (exhibited in the PIN junction) of not less than about 1.1 volts. Of cource, such a semiconductor may be employed in both of the P-layer and the N-layer The doped layers are obtained by doping the above-mentioned I-type a-Si with either an element of Group III of the Periodic Table to provide the P-type a-Si or an element of Group V of the Periodic Table to provide the N-type a-Si. If only the flexibility is desired, a PIN homojunction may be formed.

The P-type and N-type amorphous semiconductors are not particularly limited. Preferable amorphous semiconductors include amorphous silicon carbide of the formula: a-Si₍₁₋ₓ₎Cₓ, amorphous silicon nitride of the formula: a-Si(_{1-y})N_{y}, amorphous silicon carbon nitride of the formula: a-Si_{(1-x-y)}CₓN_{y} and the hydrides thereof. These amorphous silicon compounds and hydrogenated ones are prepared by a glow discharge in a mixture of a hydrogen compound of silicon such as silane a hydrogen compound of carbon or nitrogen such as a hydrocarbon or ammonia, and a doping gas.

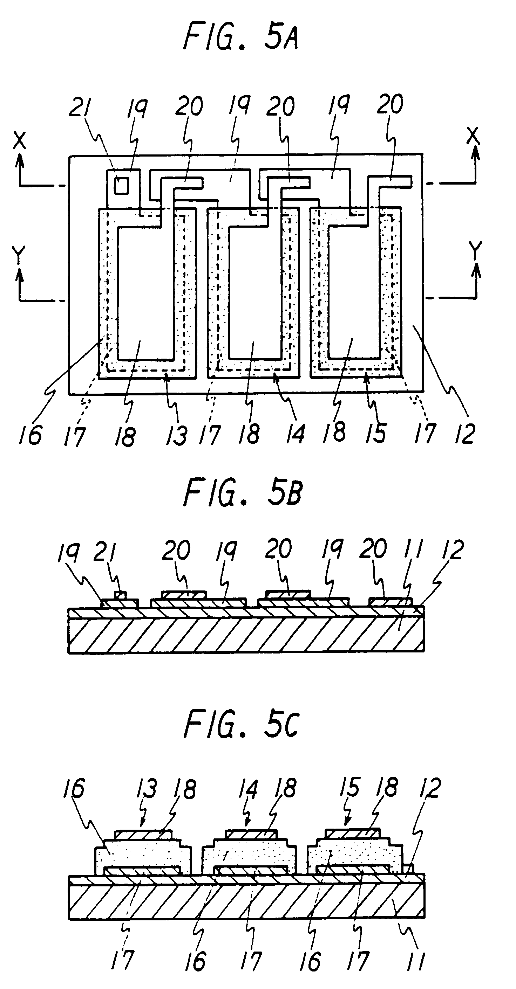

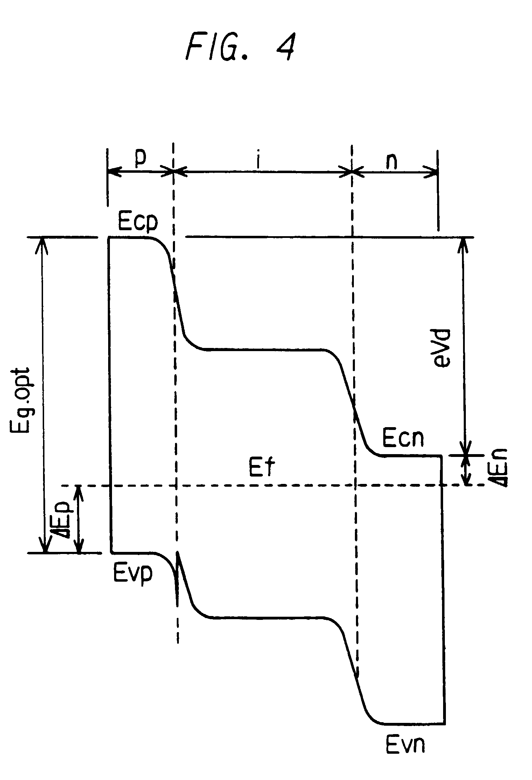

The above exemplified amorphous semiconductors have a large optical band gap, and accordingly shows a very high open circuit voltage (Voc), though it is naturally considered that the short-circuit current density (Jsc) is increased when they are used as a window material for a PIN junction photovoltaic device. In a PIN junction photovoltaic device using the above amorphous or semiconductors, there is the correlation between the diffusion potential (Vd) and the open circuit voltage of the device as depicted by the band profile of Fig. 4. The trend of the relation is almost the same without reference to the kind of the amorphous semiconductor positioned on the light impinging side. The diffusion potential (Vd) is the difference obtained by subtracting the sum of the activation energies of the P and N doped layers from the optical band gap (Eg.opt) of the amorphous semiconductor positioned on the side exposed to the light. As shown in Fig. 4, let Ecn stand for the energy level of the conduction band on the N side and Evp for the energy level of the valence band on the P side, and the activation energy ΔEp and ΔEn can be determined based on the dependency of electric conductivity on temperature. Since ΔEp = Ef - Evp holds for the P-type and ΔEn = Ecn - Ef for the N-type, there ensues eVd = Eg.opt - (ΔEp + ΔEn). In case of the incidence of light which occurs on the N side, the diffusion potential is obtained in the same manner by subtracting the Fermi levels (Ef) of the P and N layers from the optical band gap (Eg.opt) of the N-type semiconductor.

It is preferable to employ an amorphous semiconductor having an optical band gap of at least about 1.85 eV and a diffusion potential of at least about 1.1 volts. In case of fabricating a heretojunction photovoltaic device by employing such an amorphous semiconductor, the short-circuit current density (Jsc) and open circuit voltage (Voc) can be greatly improved. Also, an amorphous semiconductor having an electric conductivity of at least 10⁻⁸ (Ω cm.)⁻¹ at room temperature is preferably used, since when the electric conductivity is less than 10⁻⁸ (Ω cm.)⁻¹, the curve fill factor (FF) is small and no practical conversion efficiency is obtained.

The PIN heterojunction photovoltaic device provided according to the present invention will be described specifically below. In one typical construction as shown in Fig. 3A, this device is of the type that light impinges on the P-layer side, and is composed of metal foil 1a, electric insulating thin film layer 1b, electrode 2, N-type amorphous silicon semiconductor 3a, I-type amorphous silicon 3b, P-type amorphous or microcrystalline semiconductor 3c and transparent electrode 4. The transparent electrode 4 is desired to be formed of ITO and SnO₂, especially SnO₂, and it is directly formed on the P-type amorphous semiconductor by vapor deposition. More preferably, the transparent electrode is of two layer structure, and a SnO₂ layer having a thickness of 3 to 10 nm (30 to 100 angstroms) is further provided in the interface between the ITO layer and the P-type semiconductor layer. The P-type amorphous semiconductor layer 3c positioned on the light impinging side is desired to have a thickness of from 3 to 30 nm (30 to 300 angstroms), especially from 5 to 20 nm (50 to 200 angstroms). Although the thickness of the I-type a-Si layer is not specifically limited, it is generally selected from 250 to 1000 nm (2,500 to 10,000 angstroms). Also, the thickness of the N-type amorphous silicon semiconductor layer is not specifically limited, but is usually selected from 15 to 60 nm (150 to 600 angstroms). A heterojunction of amorphous semiconductors may be used on the opposite side to the light impinging side.

In another typical construction as shown in Fig. 3B, the device is composed of transparent electrode 4, N-type amorphous semiconductor 3a, I-type amorphous silicon 3b, P-type amorphous semiconductor 3c, electrode 2, electric insulating thin film 1b and metal foil 1a, and the transparent electrode side is exposed to the light. For instance, the heterojunction photovoltaic device of this type has a construction of transparent electrode - N-type a-Si₍₁₋ₓ₎Cₓ:H-I-type a-Si:H - P-type a-Si:H - electrode - insulating layer - metal foil. The N-type amorphous semiconductor on the light impinging side is desired to have a thickness of from 3 to 30 nm (30 to 300 angstroms), preferably from 5 to 20 nm (50 to 200 angstroms). Although the thickness of the I-type a-Si is not specifically limited, it is generally selected from 250 to 1000 nm (2,500 to 10,000 angstroms). The thickness of the P-type amorphous semiconductor layer, which is not particularly limited, is generally selected from 15 to 60 nm (150 to 600 angstroms). The material for the transparent electrode and the method for the vacuum deposition thereof are the same as described above. Although a heterojunction of the semiconductors is employed on the light impinging side in the above description, a heterojunction of amorphous semiconductors may be employed on the opposite side to the light impinging side.

A plurality of generating zones connected electrically with each other in series, each having the basic construction as shown in Figs. 3A and 3B, can be provided on a single substrate, namely an electrically insulated metal foil, for the purpose of providing a flexible, small-sized photovoltaic device capable of generating an increased photoelectromotive force.

Referring to Figs. 5A, 5B and 5C which show an embodiment of the photovoltaic device of the invention having a plurality of generating zones, numeral 11 is a metal foil, numeral 12 is an electric insulating thin film layer, and numerals 13, 14 and 15 are first, second and third generating zones formed on the insulation layer 17 of the substrate. Each of the generating zones is composed of a homojunction or heterojunction semiconductor layer 16, a first electrode 17 and a second electrode 18, both electrodes being positioned on the both sides of the layer 16. The homojunction or heterojunction layer 16 has, for instance, the structure as shown in Fig. 3A and includes a N-type layer formed on the substrate, a nondoped layer (i.e. I-type layer) and a P-type layer. The layer 16 may extend continuously throughout the first, second and third generating zones, or may be discrete as shown in the figures.

The first electrode 17 is formed of a material which is capable of coming into ohmic contact with the semiconductor, i.e. a metal such as Ni, Cr, Pt or Mo. The second electrode 18 is a transparent electrode made of SnO, SnO₂, In₂O₃ or a composite of SnO₂ and ITO formed on the SnO₂.

The first and second electrodes 17 and 18 of each of the first, second and third generating zones 13, 14 and 15 have portions 19 and 20 extending to the outside of the respective generating zones within the substrate. The extending portion 20 of the second electrode 18 of the first generating zone 13 overlaps the extending portion 19 of the first electrode 17 of the second generating zone 14 to electrically connect with each other. Similarly, the extending portion 20 of the second electrode 18 of the second generating zone 14 and the extending portion 19 of the first electrode 17 of the third generating zone are connected to each other. A connecting portion 21 made of the same materials as the second electrode 18 may be attached to the extending portion 19 of the first electrode 17 of the first generating zone 13, as occasion demands.

The photovoltaic device as shown in Figs. 5A to 5C is fabricated in the following manner. On the substrate, namely the metal foil 11 insulated with the insulation layer 12, each first electrode 17 having the extending portion 19 is first formed by means of selective etching, selective sputtering or vapor deposition. In the second step, the homojunction or heterojunction layer 16 is formed throughout the first, second and third generating zones. In that case, the presence of the layer 16 on the extending portions 19 must be avoided, the layer 16 is formed on only the desired portion by employing a mask covering the undesired portion, or after forming the layer 16 on the whole surface of the substrate provided with the electrode 17, the layer 16 on the undesired portion is removed by selective etching. In the subsequent last step, the second electrodes 18 and the connecting portion 21 are formed by selective sputtering or vapor deposition technique.

If light enters into the homojunction or heterojunction layer 16 through the second electrode 18, a voltage is generated in each of the first, second and third generating zones. Since the generating zones 13, 14 and 15 are connected to each other in series at the extending portions 19 and 20 of the first and second electrodes 17 and 18, the voltages generated at the respective zones are added, and the so added voltage is generated between the connecting portion 21 as negative electrode and the extending portion 20 of the third generating zone as positive electrode.

If the distance between the adjacent generating zones is small, there may be observed the phenomenon that an electric current directly flows between the both of the first electrodes 17 of the adjacent zones, or the both of the second electrodes 18 of the adjacent zones, namely occurrence of leakage current. However the occurrence of leakage current can be substantially eleminated by providing the generating zones at a distance of at least 1 µm., since the resistance of the homojunction or heterojunction layer 16 is from several to several tens of M at the time of light impinging. If necessary, the layer 16 may be separately formed in every generating zone, and the first electrode may be connected in series to the second electrode of the next adjacent generating zone. Also, it is advantageous for practical use to protect the photovoltaic device by covering the device from the second electrode side with close adhesion with a transparent insulating polymer film or a transparent insulating film such as SiO₂, amorphous silicon carbide, amorphous silicon nitride or amorphous silicon carbon nitride film.

In the above-mentioned embodiment, a plurality of generating zones, each including a homojunction or heterojunction photovoltaic device body, are connected to each other in series. and accordingly a flexible, small-sized photovoltaic device capable of generating a desired voltage can be provided. Also, since the insulated metal foil is employed as a substrate, the photovoltaic device can be fabricated in the same manner as a conventional photovoltaic device using a glass substrate, moreover on a mass production scale.

## Claims (Claims for the following Contracting State(s): BE, CH, LI)

1. A flexible photovoltaic device comprising a substrate (1) including a metal foil (1 a) and an electric insulating thin film (1 b), and a photovoltaic device body (3) of an amorphous silicon semiconductor, the body being formed over said electric insulating thin film and an electrode layer (2) of a metal thin film being interposed between the body and the electric insulating thin film and being in ohmic contact with the amorphous silicon semiconductor, characterized in that said insulating thin film (1 b) is a layer of an inorganic material having an electric conductivity of not more than 10⁻⁹ (Ω cm)⁻¹ during light impingement, said inorganic material being an amorphous material selected from the group consisting of silicon carbide Si₍₁₋ₓ₎Cₓ, silicon nitride Si_{1-y}N_{y}, silicon carbon nitride Si_{(1-x-y)}CₓN_{y}, and their hydrides.

2. The device of claim 1, wherein a layer of a heat resistant polymer is interposed between the metal foil (1 a) and the inorganic material film (1 b) contiguous to the electrode.

3. The device of claim 2, wherein said heat resistant polymer is a member selected from the group consisting of polyimide, polyamide, polyamidimide, polyhydantoin, polyparabanic acid, poly-p-xylylene, silicone, and cyclized polybutadiene homopolymer and copolymers.

4. The device of claim 1, wherein said amorphous silicon semiconductor has a three layer structure of a PIN junction type.

## Claims (Claims for the following Contracting State(s): DE, FR, GB, IT, NL)

1. A flexible photovoltaic device comprising a substrate (1) including a metal foil (1 a) and an electric insulating thin film (1 b), and a photovoltaic device body (3) of an amorphous silicon semiconductor, the body being formed over said electric insulating thin film and an electrode layer (2) of a metal thin film being interposed between the body and the electric insulating thin film and being in ohmic contact with the amorphous silicon semiconductor, characterized in that said insulating thin film (1 b) is a layer of an inorganic material having an electric conductivity of not more than 10⁻⁹ (Ω·cm)⁻¹ during light impingement, said inorganic material being an amorphous material selected from the group consisting of silicon carbide Si₍₁₋ₓ₎Cₓ, silicon nitride Si_{i-y}N_{y} excepting Si₃N_{4,}silicon carbon nitride Si_{(1-x-y)}CₓN_{y} and their hydrides.

2. The device of claim 1, wherein a layer of a heat resistant polymer is interposed between the metal foil (1 a) and the inorganic material film (1 b) contiguous to the electrode.

3. The device of claim 2, wherein said heat resistant polymer is a member selected from the group consisting of polyimide, polyamide, polyamidimide, polyhydantoin, polyparabanic acid, poly-p-xylylene, silicone, and cyclized polybutadiene homopolymer and copolymers.

4. The device of claim 1, wherein said amorphous silicon semiconductor has a three layer structure of a PIN junction type.

## Patentansprüche (Patentansprüche für folgende(n) Vertragsstaat(en): BE, CH, LI)

1. Flexible photoelektrische Einrichtung, die umfaßt ein Substrat (1) aus einer Metallfolie (1a) und einem elektrisch isolierenden dünnen Film (1b) und einen photoelektrischen Einrichtungskörper (3) aus einem amorphen Silicium-Halbleiter, wobei der Körper auf den elektrisch isolierenden dünnen Film aufgebracht ist und wobei eine Elektrodenschicht (2) aus einem dünnen Metallfilm zwischen dem Körper und dem dünnen elektrisch isolierenden Film angeordnet ist und sich in Ohmschem Kontakt mit dem amorphen Silicium-Halbleiter befindet, dadurch gekennzeichnet, daß der isolierende dünne Film (1b) eine Schicht aus einem anorganischen Material mit einer elektrischen Leitfähigkeit von nicht mehr als 10⁻⁹ (Ohm . cm)⁻¹ während des Auftreffens von Licht ist, wobei das anorganische Material ein Vertreter ist, der ausgewählt ist aus der Gruppe, die besteht aus Siliciumcarbid Si₍₁₋ₓ₎Cₓ, Siliciumnitrid Si_{(1-y})N_{y}, Siliciumkohlenstoffnitrid Si_{(1-x-y)}CₓN_{y} und ihren Hydriden.

2. Einrichtung nach Anspruch 1, in der eine Schicht aus einem wärmebeständigen Polymer zwischen der Metallfolie (1a) und dem an die Elektrode angrenzenden Film aus dem anorganischen Material (1b) angeordnet ist.

3. Einrichtung nach Anspruch 2, in der das wärmebeständige Polymer ein Vertreter ist, der ausgewählt ist aus der Gruppe, die besteht aus Polyimid, Polyamid, Polyamidimid, Polyhydantoin, Polyparabansäure, Poly-p-xylylen, Silicon und cyclisiertem Polybutandien-Homopolymer und Copolymer.

4. Einrichtung nach Anspruch 1, in der der amorphe Silicium-Halbleiter einen 3-Schichten-Aufbau vom PIN-Übergangszonen-Typ hat.

## Patentansprüche (Patentansprüche für folgende(n) Vertragsstaat(en): DE, FR, GB, IT, NL)

1. Flexible photoelektrische Einrichtung, die umfaßt ein Substrat (1) aus einer Metallfolie (1a) und einem elektrisch isolierenden dünnen Film (1b) und einen photoelektrischen Einrichtungskörper (3) aus einem amorphen Silicium-Halbleiter, wobei der Körper auf den elektrisch isolierenden dünnen Film aufgebracht ist und wobei eine Elektrodenschicht (2) aus einem dünnen Metallfilm zwischen dem Körper und dem dünnen elektrisch isolierenden Film angeordnet ist und sich in Ohmschem Kontakt mit dem amorphen Silicium-Halbleiter befindet, dadurch gekennzeichnet, daß der isolierende dünne Film (1b) eine Schicht aus einem anorganischen Material mit einer elektrischen Leitfähigkeit von nicht mehr als 10⁻⁹ (Ohm . cm)⁻¹ während des Auftreffens von Licht ist, wobei das anorganische Material ein Vertreter ist, der ausgewählt ist aus der Gruppe, die besteht aus Siliciumcarbid Si₍₁₋ₓ)Cₓ, Siliciumnitrid Si_{(1-y)}N_{y}, mit Ausnahme von Si₃N₄, Siliciumkohlenstoffnitrid Si_{(1-x-y)}CₓN_{y} und ihren Hydriden.

2. Einrichtung nach Anspruch 1, in der eine Schicht aus einem wärmebeständigen Polymer zwischen der Metallfolie (1a) und dem an die Elektrode angrenzenden Film aus dem anorganischen Material (1b) angeordnet ist.

3. Einrichtung nach Anspruch 2, in der das wärmebeständige Polymer ein Vertreter ist, der ausgewählt ist aus der Gruppe, die besteht aus Polyimid, Polyamid, Polyamidimid, Polyhydantoin, Polyparabansäure, Poly-p-xylylen, Silicon und cyclisiertem Polybutandien-Homopolymer und -Copolymer.

4. Einrichtung nach Anspruch 1, in der der amorphe Silicium-Halbleiter einen 3-Schichten-Aufbau vom PIN-Übergangszonen-Typ hat.

## Revendications (Revendications pour l'(les) Etat(s) contractant(s) suivant(s): BE, CH, LI)

1. Dispositif photovoltaïque flexible comprenant un substrat (1) comportant une feuille de métal (1a) et un mince film d'isolant électrique (1b), et un corps (3) de dispositif photovoltaïque constitué d'un semi-conducteur de silicium amorphe, le corps étant formé au-dessus dudit mince film d'isolant électrique et une couche formant électrode (2) d'un mince film métallique, étant interposée entre le corps et le mince film d'isolant électrique, qui est en contact ohmique avec le semi-conducteur de silicium amorphe, caractérisé en ce que ledit mince film d'isolant (1b) est une couche constituée d'un matériau inorganique ayant une conductivité électrique pas plus grande que 10⁻⁹ (Ohm . cm)⁻¹ lors d'une exposition à la lumière, ledit matériau inorganique étant une élément choisi parmi le groupe constitué du carbure de silicium Si₍₁₋ₓ₎Cₓ, du nitrure de silicium Si_{(1-y)}N_{y}, du nitrure de carbone silicium Si_{(1-x-y)}CₓN_{y} et de leurs hydrures.

2. Dispositif selon la revendication 1, dans lequel une couche de polymère résistant à la chaleur est interposée entre la feuille de métal (1a) et le film de matériau inorganique (1b) contigu à l'électrode.

3. Dispositif selon la revendication 2, dans lequel ledit polymère résistant à la chaleur est un élément choisi parmi le groupe constitué de polyimide, polyamide, polyamidimide, polyhydantoïne, acide polyparabanique, poly-p-xylylène, silicone, et d'homopolymère et de copolymères de polybutandiène cyclisé.

4. Dispositif selon la revendication 1, dans lequel ledit semi-conducteur de silicium amorphe a une structure à trois couches du type jonction PIN.

## Revendications (Revendications pour l'(les) Etat(s) contractant(s) suivant(s): DE, FR, GB, IT, NL)

1. Dispositif photovoltaïque flexible comprenant un substrat (1) comportant une feuille de métal (1a) et un mince film d'isolant électrique (1b), et un corps (3) de dispositif photovoltaïque constitué d'un semi-conducteur de silicium amorphe, le corps étant formé au-dessus dudit mince film d'isolant électrique et une couche formant électrode (2) d'un mince film métallique, étant interposée entre le corps et le mince film d'isolant électrique qui est en contact ohmique avec le semi-conducteur de silicium amorphe, caractérisé en ce que ledit mince film d'isolant (1b) est une couche constituée d'un matériau inorganique ayant une conductivité électrique pas plus grande que 10⁻⁹ (Ohm . cm)⁻¹ lors d'une exposition à la lumière, ledit matériau inorganique étant une élément choisi parmi le groupe constitué du carbure de silicium Si₍₁₋ₓ₎Cₓ, du nitrure de silicium Si_{(1-y)}N_{y}, à l'exception de Si₃N₄, du nitrure de carbone silicium Si_{(1-x-y)}CₓN_{y} et de leurs hydrures.

2. Dispositif selon la revendication 1, dans lequel une couche de polymère résistant à la chaleur est interposée entre la feuille de métal (la) et le film de matériau inorganique (1b) contigu à l'électrode.

3. Dispositif selon la revendication 2, dans lequel ledit polymère résistant à la chaleur est un élément choisi parmi le groupe constitué de polyimide, polyamide, polyamidimide, polyhydantoïne, acide polyparabanique, poly-p-xylylène, silicone, et d'homopolymère et de copolymères de polybutandiène cyclisé.

4. Dispositif selon la revendication 1, dans lequel ledit semi-conducteur de silicium amorphe a une structure à trois couches du type jonction PIN.
